# EUROPEAN PATENT APPLICATION

(11) **EP 4 727 303 A1**
(43) Date of publication of application: **15.04.2026**
(21) Application number: 24899259.6
(22) Date of filing: 16.07.2024
(51) Int. Cl.: H10F 71/00, H10F 19/90, H10F 19/80

(54) **SOLAR CELL MODULE MANUFACTURING METHOD, AND SOLAR CELL MODULE**

(30) Priority: 04.12.2023 CN 202311647091
(71) Applicant: CHINT New Energy Technology Co., Ltd., Haining, Zhejiang 314400 (CN)
(72) Inventor: HE, Chenxu, Jiaxing, Zhejiang 314400 (CN); WU, Guoxing, Jiaxing, Zhejiang 314400 (CN); JIN, Yeyi, Jiaxing, Zhejiang 314400 (CN); HSU, Wei-Chih, Jiaxing, Zhejiang 314400 (CN)
(74) Representative: PGA S.p.A., Milano, Succursale di Lugano
(86) International application number: PCT/CN2024/105687
(87) International publication number: WO 2025/118608

(57) **Abstract**

A solar cell module manufacturing method, and a solar cell module, which are applied to the technical field of solar cells. The method comprises: laying a plurality of cells and welding strips on a whole continuous inner-layer encapsulation adhesive film, and encapsulating the welding strips on the surfaces of the cells by means of an inner-layer encapsulation adhesive film, so as to form cell strings; connecting the cell strings to each other; and laminating and encapsulating a front cover plate, the cell strings connected to each other and a back plate by means of an outer-layer encapsulation adhesive film, so as to form a laminated member; and preparing a solar cell module on the basis of the laminated member. By means of two totally successive encapsulations, in the first encapsulation, the welding strips are connected to the cells by means of the adhesive film, and in the second encapsulation, the cell strings are encapsulated, such that uniform and high-quality encapsulation can be realized; by means of increasing the amount of the adhesive film in a cell gap, laminated bubbles due to local shortages of an adhesive of a low-flow adhesive film can be eliminated; and high-density encapsulation between the cell strings can be achieved by means of two encapsulations, and the efficiency of a photovoltaic module is improved.

## Description

### CROSS REFERENCE TO RELATED APPLICATIONS

This application claims the priority of Chinese Patent Application No. 202311647091.3, filed with the China National Intellectual Property Administration on December 4, 2023, and titled with "SOLAR CELL MODULE MANUFACTURING METHOD, AND SOLAR CELL MODULE", which is hereby incorporated by reference in its entirety.

### FIELD

The present disclosure relates to the technical field of solar cell, especially relates to a solar cell module manufacturing method and a solar cell module.

### BACKGROUND

In the busbar-free and dense-busbar technique, silver busbars and flat solder ribbons with multiple fine copper wires (strips) plated are replaced with a special coating, thereby the shading area on the front surface of the cell is significantly reduced and the consumption of silver paste is reduced, which in turn increases the conversion efficiency of photovoltaic modules and reduces manufacturing costs. However, this technique requires that dozens of tin-plated fine copper wires (strips) be laid on the cells and welded to the fine gridlines. A film layer is required to pre-arrange and fix the tin-plated copper wires (strips), and to support and position them during the lamination and welding process.

In conventional encapsulation films, lamination is carried out by directly bonding the outside of the cell strings, thereby sealing all cells inside the module in a single counterflow sealing. In such a lamination process, the cells inside the encapsulation film are subjected to uneven pressure or experience slippage between the cells and the film. On the one hand, the module design cannot achieve a small spacing between cell strings, i.e., high-density encapsulation is not available; on the other hand, due to relative slippage of the cells, non-contact between cell strings may easily occur, resulting in internal electrical short circuits of the module and consequently causing substantial loss. Therefore, how to provide a solar cell module manufacturing method with a high yield is a technical problem urgently to be solved by those skilled in the art.

### SUMMARY

The objective of the present disclosure is to provide a method for manufacturing a solar cell module with a high yield rate. Another objective of the present disclosure is to provide a solar cell module having a high yield.

To solve the above technical problems, the present disclosure provides a method for manufacturing a solar cell module, comprising steps of:
laying a plurality of cells and a solder ribbon on an integral continuous inner encapsulation adhesive film, and encapsulating the solder ribbon on a surface of the cells through the inner encapsulation adhesive film to form a cell string; wherein the inner encapsulation adhesive film is used to fixedly connect the solder ribbon to the surface of the cells;
connecting the cell strings to each other;
laminating and encapsulating a front cover plate, the interconnected cell strings, and a backsheet through an outer encapsulation adhesive film to form a laminated assembly; wherein the outer encapsulation adhesive film is located between the cell strings and the front cover plate, and between the cell strings and the backsheet; and
fabricating the solar cell module based on the laminated assembly.

Optionally, the step of laying a plurality of cells and a solder ribbon on an integral continuous inner encapsulation adhesive film and encapsulating the solder ribbon on a surface of the cells through the inner encapsulation adhesive film to form a cell string comprises steps of:
laying an integral continuous first inner encapsulation adhesive film on a surface of a back plate;
laying the solder ribbon and a plurality of cells on a surface of the first inner encapsulation adhesive film according to a preset structure of the cell strings;
laying a second inner encapsulation adhesive film corresponding to each of the cells on a surface of the cell facing away from the back plate; wherein the first inner encapsulation adhesive film and the second inner encapsulation adhesive films are used to fixedly connect the solder ribbon to the surface of the cells; wherein a gap is present between adjacent second inner encapsulation adhesive films; and
placing a pressing tool on a surface of the second inner encapsulation adhesive film and performing heating to encapsulate the solder ribbon on a surface of the cells to form the cell string.

Optionally, the back plate has an adsorption structure to adsorb the first inner encapsulation adhesive film.

Optionally, the first inner encapsulation adhesive film has a hollow structure in a non-encapsulation region corresponding to outer side of the solder ribbon, to allow the adsorption structure to adsorb the cell through the hollow structure.

Optionally, the second inner encapsulation adhesive film has a hollow structure in a non-encapsulation region corresponding to outer side of the solder ribbon.

Optionally, the second inner encapsulation adhesive film is a plurality of films covering the solder ribbon located on a surface of the cells facing away from the back plate.

Optionally, the cell includes a busbar-free cell; and the solder ribbon is a low-temperature solder ribbon.

Optionally, the outer encapsulation adhesive film has a fluidity greater than that of the inner encapsulation adhesive film.

Optionally, the step of fabricating the solar cell module based on the laminated assembly comprises steps of:
performing edge framing protection and junction box installation on the laminated assembly to obtain the solar cell module.

Optionally, the step of connecting the cell strings to each other comprises:
stacking and isolating the edge of adjacent cell strings through inner encapsulation adhesive film extending beyond the side of the cells, so as to overlap the cell strings.

Optionally, the step of stacking and isolating the edge of adjacent cell strings through inner encapsulation adhesive film extending beyond the side of the cell so as to overlap the cell strings comprises:
stacking and isolating the edge of adjacent cell strings through the first inner encapsulation adhesive film extending beyond the side of the cell strings, so as to overlap the cell strings.

Optionally, the step of laying the second inner encapsulation adhesive film corresponding to each of the cells on the surface of the cells facing away from the back plate comprises:
stacking and isolating the edge of adjacent cells through the second inner encapsulation adhesive film extending beyond the side of the cell, so as to overlap the cells.

The present disclosure further provides a solar cell module, comprising a cell string, an outer encapsulation adhesive film, a front cover plate and a backsheet;
wherein the cell string is obtained by laying a plurality of cells and a solder ribbon on an integral continuous inner encapsulation adhesive film, and encapsulating the solder ribbon on a surface of the cells through the inner encapsulation adhesive film; and the inner encapsulation adhesive film is used to fixedly connect the solder ribbon to a surface of the cells;
wherein a plurality of the cell strings is connected to each other, and the outer encapsulation adhesive film connects the front cover plate, the connected cell strings and the backsheet to each other.

Optionally, the inner encapsulation adhesive film comprises an integral continuous first inner encapsulation adhesive film and a second inner encapsulation adhesive film corresponding to the cells;
wherein the plurality of cells in the cell string and the solder ribbon are laid on a surface of the first inner encapsulation adhesive film according to a preset structure of the cell strings, the second inner encapsulation adhesive films is laid on a surface of the cells facing away from the first inner encapsulation adhesive film, and a gap is present between adjacent second inner encapsulation adhesive films.

Optionally, the edge of adjacent cell strings are stacked and isolated from each other through an inner encapsulation adhesive film extending beyond the side of the cells so as to overlap the cell strings.

Optionally, the edge of adjacent cell strings are stacked and isolated from each other through a first inner encapsulation adhesive film extending beyond the side of the cells string so as to overlap the cell strings.

Optionally, the edge of adjacent cells in the cell strings are stacked and isolated from each other through a second inner encapsulation adhesive film extending beyond the side of the cells so as to overlap the cells.

Optionally, the second inner encapsulation adhesive films correspond one-to-one to the solder ribbons on a side of the cells and encapsulate the corresponding solder ribbons on a surface of the cells.

The present disclosure provide a method for manufacturing a solar cell module comprising:
laying a plurality of cells and solder ribbons on an integral continuous inner encapsulation adhesive film, and encapsulating the solder ribbon on a surface of the cell through the inner encapsulation adhesive film to form a cell string; wherein the inner encapsulation adhesive film is configured to fixedly connect the solder ribbon to the surface of the cell; interconnecting the cell strings; laminating and encapsulating a front cover plate, the interconnected cell strings, and a backsheet through an outer encapsulation adhesive film to form a laminated assembly; wherein the outer encapsulation adhesive film is located between the cell strings and the front cover plate, and between the cell strings and the backsheet; fabricating a solar cell module based on the laminated assembly.

By performing two encapsulation processes respectively, wherein a first encapsulation connects the solder ribbons with the cells through the adhesive film, and a second encapsulation encapsulates the cell strings, a uniform and high-quality encapsulation can be accomplished. By increasing the amount of gap-filling adhesive film between the cells, lamination bubbles arising from local adhesive deficiency of a low-flow adhesive film can be eliminated. The double encapsulations enable high-density encapsulation between the cell strings, thereby improving the efficiency of a photovoltaic module.

The disclosure further provides a solar cell module, which likewise achieves the above advantageous effects, which is not repeated here.

### BRIEF DESCRIPTION OF DRAWINGS

To more clearly illustrate the technical solutions of embodiments of the disclosure or of the conventional art, brief descriptions of the drawings required in the descriptions of the embodiments or the conventional art are provided below. It is apparent that the drawings described below merely depict some embodiments of the disclosure. For those ordinary skilled in the art, other drawings can be obtained based on these drawings without inventive effort.
FIG. 1 is a flowchart illustrating a method for manufacturing a solar cell module according to an embodiment of the present disclosure;
FIG. 2 is a flowchart illustrating a specific method for manufacturing a solar cell module according to an embodiment of the present disclosure;
FIG. 3 is a schematic diagram of a first encapsulation according to an embodiment of the present disclosure;
FIG. 4 is a schematic side view of a cell string during the first encapsulation;
FIG. 5 is a schematic top view of a cell string during the first encapsulation;
FIG. 6 is a schematic bottom view of a cell string during the first encapsulation;
FIG. 7 is a schematic diagram of a connection structure between adjacent cell strings;
FIG. 8 is a schematic diagram of a test structure corresponding to FIG. 7;
FIG. 9 is a schematic top view of the first encapsulation in a first solar cell module manufacture method;
FIG. 10 is a schematic bottom view of the first encapsulation in the first solar cell module manufacture method;
FIG. 11 is a schematic top view of the first encapsulation in a second solar cell module manufacture method;
FIG. 12 is a schematic bottom view of the first encapsulation in the second solar cell module manufacture method;
FIG. 13 is a schematic top view of the first encapsulation in a third solar cell module manufacture method;
FIG. 14 is a schematic bottom view of the first encapsulation in the third solar cell module manufacture method;
FIG. 15 is a schematic top view of the first encapsulation in a fourth solar cell module manufacture method.

In the drawings: 1. cell; 2. sober ribbon; 3. inner encapsulation adhesive film; 31. first inner encapsulation adhesive film; 32. second inner encapsulation adhesive film; 33. hollowed structure; 4. back plate; 41. adsorption structure; 42. heating source; 5. elastomer; 6. pressing tool; 7. overlapping region.

### DETAILED DESCRIPTION

The essential of the present disclosure is to provide a method for manufacturing a solar cell module. In the prior art, the traditional adhesive film is directly laminated on the outer side of the cell string, thereby sealing all cells in the module in a single counterflow sealing. In such a lamination process, the cells inside the encapsulation adhesive film are subjected to uneven pressure or experience slippage between the cells and the film. On the one hand, the module design cannot achieve a small spacing between cell strings, i.e., high-density encapsulation is not available; on the other hand, due to relative slippage of the cells, non-contact between cell strings may easily occur, resulting in internal electrical short circuits of the module and consequently causing substantial loss.

The present disclosure provides a method for manufacturing a solar cell module, comprising: laying a plurality of cells and a solder ribbon on an integral continuous inner encapsulation adhesive film, and encapsulating the solder ribbon on a surface of the cells through the inner encapsulation adhesive film to form a cell string; wherein the inner encapsulation adhesive film is used to fixedly connect the solder ribbon to the surface of the cells; connecting the cell strings to each other; laminating and encapsulating a front cover plate, the interconnected cell strings, and a backsheet through an outer encapsulation adhesive film to form a laminated assembly; wherein the outer encapsulation adhesive film is located between the cell strings and the front cover plate, and between the cell strings and the backsheet; and fabricating the solar cell module based on the laminated assembly.

By performing two encapsulation processes respectively, wherein a first encapsulation connects the solder ribbons with the cells through the adhesive film, and a second encapsulation encapsulates the cell strings, a uniform and high-quality encapsulation can be accomplished. By increasing the amount of gap-filling adhesive film between the cells, lamination bubbles arising from local adhesive deficiency of a low-flow adhesive film can be eliminated. The double encapsulations enable high-density encapsulation between the cell strings, thereby improving the efficiency of a photovoltaic module.

To enable those skilled in the art to better understand the technical solution of the present disclosure, the present disclosure is further described below in detail with reference to the accompanying drawings and specific embodiments. It is apparent that the embodiments described are merely part of the embodiments of the present disclosure, rather than all embodiments. Based on the embodiments of the present disclosure, all other embodiments obtained by a person skilled in the art without inventive effort shall fall within the scope of protection of the present disclosure.

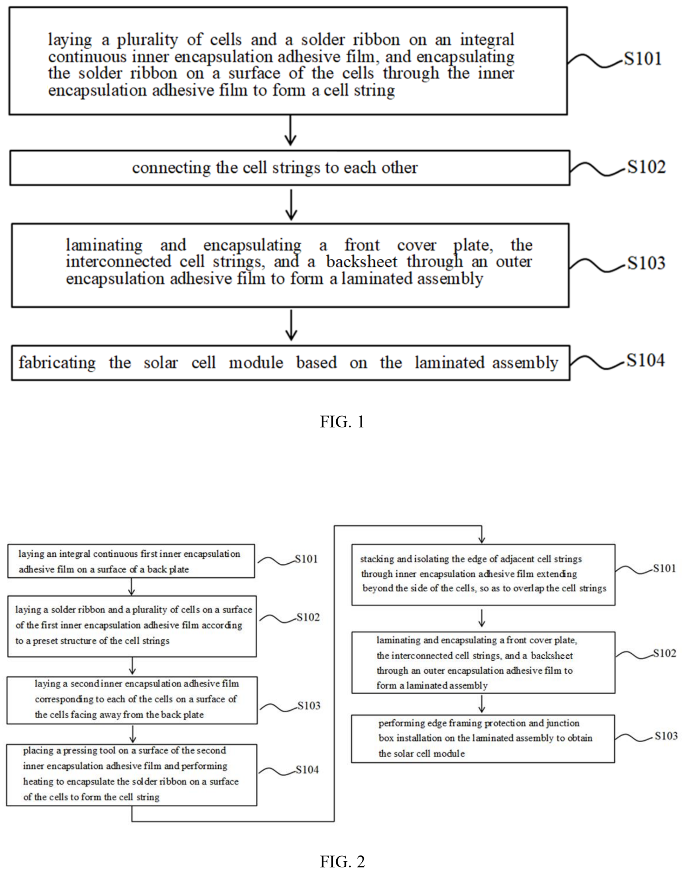

Reference is made to FIG. 1, which is a flowchart illustrating a solar cell module manufacture method provided in an embodiment of the present disclosure.

As shown in FIG. 1, in the embodiment of the present disclosure, the method for manufacturing a solar cell module comprises steps of:
S101: laying a plurality of cells and a solder ribbon on an integral continuous inner encapsulation adhesive film, and encapsulating the solder ribbon on a surface of the cell through the inner encapsulation adhesive film to form a cell string.

In the embodiment of the present disclosure, the inner encapsulation adhesive film 3 is used to fixedly connect the solder ribbon 2 to a surface of the cell 1. Therefore, in the present embodiment, the inner encapsulation adhesive film 3 is a low-flow adhesive film, which is capable of enhancing the fixing effect and reducing undesired situations such as poor-soldering and over-soldering. Specifically, in this step, an integral continuous inner encapsulation adhesive film 3 is firstly provided, and then a plurality of cell 1 and the corresponding solder ribbons 2 are laid on a surface of the continuous inner encapsulation adhesive film 3 for encapsulation to form a cell string. For the cell string, the integral continuous inner encapsulation adhesive film 3 extends from one end of the cell string to the other end without breakage.

This step corresponds to a first encapsulation for the cell 1 and the solder ribbons 2, such that the cell 1 and the solder ribbon 2 are relatively fixed to form the cell string. Therefore, the adhesive film used in this step is a low-flow adhesive film, and using the low-flow film enables the cell 1 and the solder ribbon 2 to be relatively fixed.

In the present embodiment, the cell 1 comprises a busbar-free cell 1, and the solder ribbon 2 is a low-temperature solder ribbon. That is, the inner encapsulation adhesive film 3 is mainly used to achieve relative fixing between the busbar-free cell 1 and the solder ribbon 2. Naturally, in the present embodiment, the cell 1 may be a PERC (Passivated Emitter and Rear Cell) cell, a TOPCon (Tunnel Oxide Passivated Contact) cell, an HJT (Hetero-junction with Intrinsic Thin-layer) cell, or a back-contact cell, including but not limited to busbar-free cell. The solder ribbon 2 generally is a low-temperature solder ribbon with a melting point of outer surface of 90°C to 137°C. Naturally, in the present embodiment, the types of the cell 1 and the solder ribbon 2 are not specifically limited and depend on actual conditions.

In the present embodiment, the inner encapsulation adhesive film 3 is required to wrap at least 80% of the length of the solder ribbon 2, and the inner encapsulation adhesive film 3 only forms a weak adhesion to the cell 1, and the ends of the solder ribbon 2 are not required to be covered.

In the embodiment of the present disclosure, the inner encapsulation adhesive film 3 may be PVB (polyvinyl butyral) or one of EVA (ethylene-vinyl acetate copolymer), POE (polyolefin elastomer), or polyolefin materials having a crosslinking degree of 10% to 75%. A single-layer inner encapsulation adhesive film 3 generally has a thickness of 10 µm to 900 µm, including the values at both ends. The specific content of this step will be described in detail in the embodiments of the disclosure below and will not be repeated here.

S102: connecting the cell strings to each other

In this step, the formed cell strings are required to be connected in series/parallel, and structures such as busbar is provided to achieve the interconnection between the cell strings. In the present embodiment, the spacing between adjacent cell strings is generally 1 mm to 1.5 mm, thereby ensuring a very small interval between the cell strings and ensuring that the final solar cell module has a very high arrangement density.

S103: laminating and encapsulating the front cover plate, the interconnected cell strings, and the backsheet through an outer encapsulation adhesive film to form a laminate assembly.

In the present embodiment, the outer encapsulation adhesive film is located between the cell strings and the front cover plate, and between the cell strings and the backsheet.

In this step, a second encapsulation is performed on the cell strings. The second encapsulation is similar to a conventional encapsulation, in which the front cover plate, the cell strings, and the backsheet are laminated and connected through the outer encapsulation adhesive film to form the laminate assembly. The front cover plate may be a front glass or a front transparent plate, and the backsheet may be a rear glass or a rear metal plate. The interconnected cell strings are positioned in the middle. An outer encapsulation adhesive film is provided between the cell strings and the front cover plate for connection, and another outer encapsulation film is provided between the cell strings and the backsheet for connection. The stacked structure comprising the outer encapsulation adhesive film, the front cover plate, the cell strings, and the backsheet is encapsulated through lamination. The outer encapsulation adhesive film may be PVB or one or more co-extruded structures of EVA, POE, or polyolefin materials, and its thickness is generally 10 µm to 5 mm, including the values at both ends.

In the present embodiment, since the solder ribbon 2 and the cell 1 are pre-fixed through the inner encapsulation adhesive film 3, the outer encapsulation adhesive film used in this step may be a high-flow adhesive film. That is, in the present embodiment, the flowability of the outer encapsulation adhesive film needs to be greater than that of the inner encapsulation adhesive film 3. The high-flow adhesive film can effectively fill the gaps between the cell strings and avoid bubbles in the laminate assembly. Of course, in the present embodiment, the outer adhesive encapsulation film may also be a low-flow adhesive film, and no specific limitation is imposed herein.

S104: fabricating the solar cell module based on the laminate assembly

In this step, components such as a frame and connectors will be set based on the above laminate assembly to manufacture the solar cell module.

The embodiment of the present disclosure provides a method for manufacturing a solar cell module. By performing two encapsulation processes respectively, wherein a first encapsulation connects the solder ribbons 2 with the cells 1 through the adhesive film, and a second encapsulation encapsulates the cell strings, a uniform and high-quality encapsulation can be accomplished. By increasing the amount of gap-filling adhesive film between the cells, lamination bubbles arising from local adhesive deficiency of a low-flow adhesive film can be eliminated. The double encapsulations enable high-density encapsulation between the cell strings, thereby improving the efficiency of a photovoltaic module.

The detailed description of the solar cell module manufacture method provided in the present disclosure will be set forth in the embodiments of the present disclosure below.

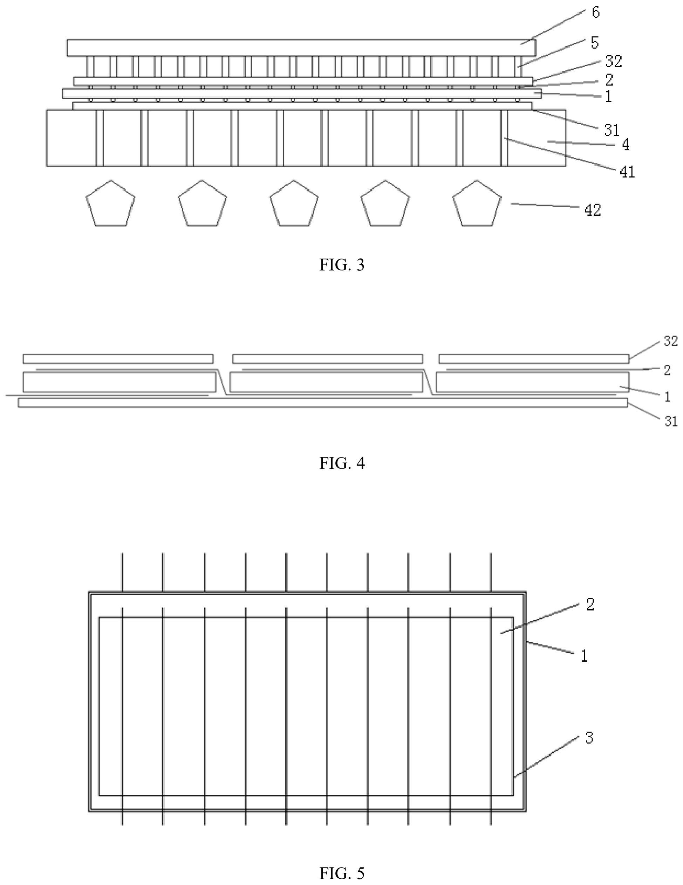

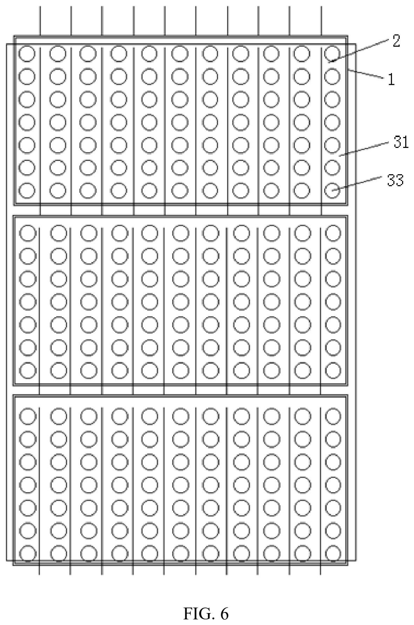

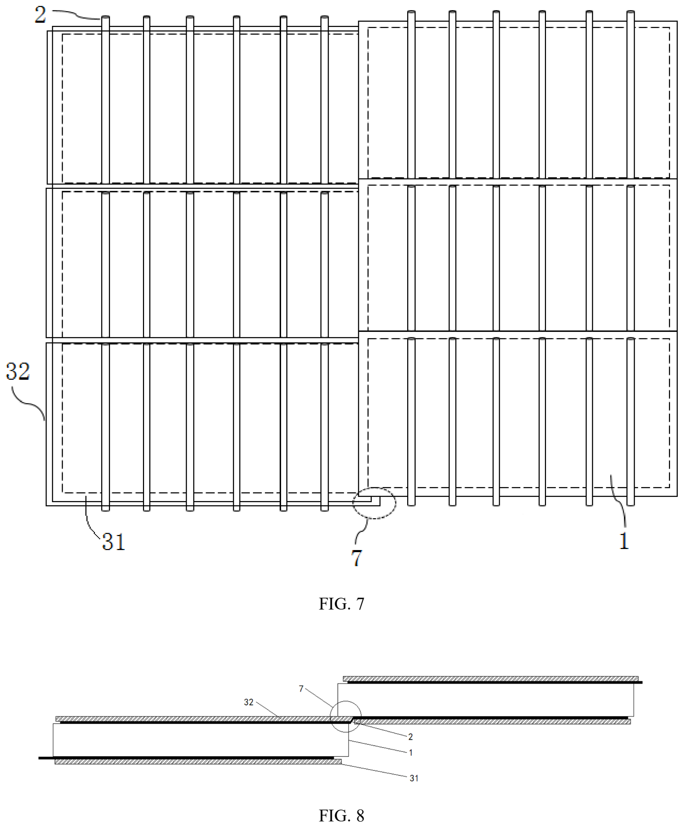

Reference is made to FIG. 2 to FIG. 8, wherein FIG. 2 is a flowchart illustrating a specific method for manufacturing a solar cell module according to an embodiment of the present disclosure; FIG. 3 is a schematic diagram of a first encapsulation according to an embodiment of the present disclosure; FIG. 4 is a schematic side view of a cell string during the first encapsulation; FIG. 5 is a schematic top view of a cell string during the first encapsulation; FIG. 6 is a schematic bottom view of a cell string during the first encapsulation; FIG. 7 is a schematic diagram of a connection structure between adjacent cell strings; FIG. 8 is a schematic diagram of a test structure corresponding to FIG. 7.

Referring to Fig. 2, in the embodiment of the present disclosure, the method for manufacturing a solar cell module comprises:
S201: laying an integral continuous first inner encapsulation film on a surface of a back plate.

As shown in FIG. 3, the back plate 4 used in the present embodiment is required to be movable at the bottom and comprise a lower adsorption back plate 4, wherein the movable bottom ensures that the cell 1 can be moved for encapsulation, and the lower adsorption indicates that the back plate 4 comprises an adsorption structure 41 used to fix the structures provided on the surface of the back plate 4.

In this step, an integral continuous first inner encapsulation adhesive film 31 is laid on the surface of the back plate 4, so that the cell string is subsequently manufactured based on the continuous first inner encapsulation adhesive film 31.

S202: laying the solder ribbon and a plurality of cells on a surface of the first inner encapsulation adhesive film according to a preset cell string structure

As shown in FIG. 4 and FIG. 5, in this step, the solder ribbon 2 and a plurality of cells 1 are required to be laid on a surface of the first inner encapsulation adhesive film 31 according to the preset cell string structure. For example, when both surfaces of the cell 1 need to be provided with solder ribbons 2, in this step, the operations of drawing the solder ribbon 2 and placing the cell 1 are specifically alternately performed, until the cell string of the preset structure is reached.

S203: laying a second inner encapsulation adhesive film corresponding to each of the cells on the surface of the cells facing away from the back plate.

In the embodiment of the present disclosure, both the first inner encapsulation adhesive film 31 and the second inner encapsulation adhesive film 32 are used to fix and connect the solder ribbon 2 to a surface of the cell 1. Therefore, in the present embodiment, both the first inner encapsulation adhesive film 31 and the second inner encapsulation adhesive film 32 are low-flow adhesive films. In this step, the second inner encapsulation adhesive film 32 is laid on the surface of the cell 1 on the side facing away from the back plate 4, and the second inner encapsulation adhesive film 32 needs to cover the solder ribbon 2 provided on the surface of the cell 1 on the side facing away from the back plate 4, so as to encapsulate the solder ribbons 2 on both surfaces of the cell 1. The specific content of the first inner encapsulation adhesive film 31 and the second inner encapsulation adhesive film 32 may refer to the above description of the inner encapsulation adhesive film 3, and will not be repeated herein.

It should be noted that, in the present embodiment, the second encapsulation adhesive film 32 is the second inner encapsulation adhesive film 32 corresponding to each cell 1, i.e., one second encapsulation adhesive film 32 corresponds only to one cell 1.

As shown in FIG. 8, furthermore, in the present embodiment, the above S203 may specifically comprise: stacking and isolating the edge of adjacent cells 1 through the second inner encapsulation adhesive film 32 extending beyond the side of the cell 1, so as to overlap the cells 1. That is, in the present embodiment, the second inner encapsulation adhesive film 32 may be further used to achieve isolation and stacking between the cells 1. The second inner encapsulation adhesive film 32 is placed in the overlapping region 7 between two stacked cells 1, so that the two stacked cells 1 are isolated from each other to form a cell string. Therefore, adjacent cells 1 within a single cell string may be isolated and stacked via the second inner encapsulation adhesive film 32, thereby improving micro-crack issues of the cells 1, eliminating the gaps between adjacent cells 1, and reducing the non-power-generating area of the module.

The specific structure of the second inner encapsulation adhesive film 32 and the specific position of the second inner encapsulation adhesive film 32 on the cell 1 will be described in detail in the embodiments of the present disclosure below. It may have various structures and may form various combined structures with the cell 1. One example structure comprises: a plurality pieces of the second inner encapsulation adhesive film 32, and a plurality of solder ribbons 2 set on one side of each cell 1; the second inner encapsulation adhesive films 32 correspond one-to-one to the solder ribbons 2 on one side of the cell 1 and encapsulate the corresponding solder ribbons 2 on the surface of the cell 1. That is, in this structure, one solder ribbon on a surface of a cell corresponds to one second inner encapsulation adhesive film 32, and the second inner encapsulation adhesive film 32 extends beyond the edge of the cell 1 onto the above overlapping region 7 to achieve the stacking of adjacent cells 1. In this structure, a plurality of individual second inner encapsulation adhesive films 32 is used. During manufacturing, the adhesive film only needs to be unwound and cut, saving the robotic-arm adsorption and picking process, and reducing bubble generation. Each solder ribbon is covered by a second inner encapsulation adhesive film 32, which can reduce stacking compression stress.

S204: placing a pressing tool on the surface of the second inner encapsulation adhesive film and performing heating to encapsulate the solder ribbon on a surface of the cell, forming a cell string.

In this step, a pressing tool 6 is placed on the surface of the laid structure to apply pressure. An elastomer 5 may be provided between the pressing tool 6 and the second inner encapsulation adhesive film 32. The movable back plate 4 drives the laid structure to a heating source 42 for heating, so as to perform the first encapsulation on the cells 1 and form the cell string. The temperature of the heating source 42 heating the inner encapsulation adhesive films 3 is typically 50 °C to 200 °C, and the pressure of the pressing tool 6 pressing the inner encapsulation adhesive films 3 is typically 0.1 N/cm² to 100 N/cm².

As shown in FIG. 6, it should be noted that in this embodiment the adsorption structure 41 provided on the back plate 4 is used for adsorbing the first inner encapsulation adhesive film 31 laid on one side surface of the back plate 4. However, in order to enhance the fixing effect of the back plate 4 on the cells 1, it is preferable that a hollowed structure 33 is provided in the non-encapsulation region of the first inner encapsulation adhesive film 31 corresponding to the outer side of the solder ribbon 2, such that the adsorption structure 41 adsorbs the cells 1 through the hollowed structure 33. By providing the hollowed structure 33, the adsorption structure 41 of the back plate 4 can directly adsorb the cells 1 through the hollowed structure 33, thereby enabling the back plate 4 to directly fix the cells 1 and preventing relative sliding between the cells 1 and the first inner encapsulation adhesive film 31 during the encapsulation process. The hollowed structure 33 provided on the first inner encapsulation adhesive film 31 may be a round, elliptical, or rectangular hollowed structure provided outside the corresponding solder ribbon region, or allow the first inner encapsulation adhesive film 31 to be presented as multiple adhesive films that only cover the solder ribbon regions. The hollowed structure 33 may be set as needed and is not specifically limited herein. In the present embodiment, the length of the first inner encapsulation adhesive film 31 may be slightly larger or slightly smaller than the length of the cell string. When the first inner encapsulation adhesive film 31 is an entire adhesive film, its width typically extends beyond the outer soldering ribbon by 2 mm, and the maximum extension on at least one side is 20 mm beyond the cell width. When the first inner encapsulation adhesive film 31 is multiple adhesive films only covering the soldering ribbon region and having the same length, their width is typically 5 mm to 15 mm, and a non-encapsulation region is present between the multiple adhesive films only covering the solder ribbon region.

In the present embodiment, the second inner encapsulation adhesive film 32 is further provided with a hollowed structure 33 in the non-encapsulation region corresponding to the outer side of the solder ribbon 2. A hollowed structure 33 may also be provided with the second inner encapsulation adhesive film corresponding to the non-encapsulation region32, which can reduce the usage amount of encapsulation adhesive film and lowers cost; furthermore, the hollowed structure 33 allows the subsequent outer high-flow outer encapsulation adhesive film to remain capable of penetration, eliminating encapsulation bubbles, and avoiding damage to the first encapsulation during the subsequent second encapsulation process and preventing poor soldering.

Similar to the above second inner encapsulation adhesive film 32 provided with the hollowed structure 33, the second inner encapsulation adhesive film 32 may be configured as multiple adhesive films covering the soldering ribbons 2 on the side surface of the cell 1 facing away from the back plate 4. This structure ensures that there is a gap between the multiple adhesive films, and the function of this gap is equivalent to the function of the hollowed structure 33 described above, and will not be further repeated here. When the second inner encapsulation adhesive film 32 is an entire adhesive film, its width extends 2 mm beyond the outer soldering ribbon, and its length corresponds to the cell length ±5 mm along the laying direction of the cell. When the second inner encapsulation adhesive film 32 is multiple adhesive films only covering the solder ribbon region with the same length, their width is typically 5 mm to 15 mm.

S205: stacking and isolating the edge of adjacent cell strings through the first inner encapsulation adhesive film extending beyond the side of the cells, so as to overlap the cell strings.

As shown in FIG. 7, in the present embodiment, the adjacent two cell strings may be connected in an overlapping manner. In the present embodiment, the adjacent cell strings have opposite ends, and the ends may be located on a surface of only one cell 1 or may include the ends of multiple cells 1. In order to increase the firmness of the connection between the cell strings, the overlapping ends of the cell strings generally include the ends of multiple cells 1 on one side.

An overlapping region 7 is formed between the two overlapped cell strings. In the present embodiment, the edges of the adjacent cell strings are isolated and stacked by the inner encapsulation adhesive films 3 extending beyond the side surfaces of the cells 1, typically by the first inner encapsulation adhesive film 31 extending beyond the sides of the cell strings. That is, this step may specifically comprise: isolating and stacking the edges of the adjacent cell strings through the first inner encapsulation adhesive film 31 extending beyond the sides of the cell strings, so as to overlap the cell strings. The isolating and stacking refers to placing the portion of the inner encapsulation adhesive film 3 extending beyond the side surfaces of the cells 1, typically the extended portion of the first inner encapsulation adhesive film 31, in the overlapping region 7 between the two stacked cell strings, thereby the two cell strings are isolated. That is, the edge portion of the first inner encapsulation adhesive film 31 is clamped within the overlapping region 7 by the edge portion of the two adjacent cell strings. This design may reduce the stress in the overlapping region 7, avoid hidden cracks of the cells, eliminate the gap between the adjacent cell strings, and reduce the non-power-generating region of the module. Certainly, in the present embodiment, the cell strings may also be placed through other structures, and the cell strings may be fixed on the same plane without direct contact. The arrangement structure of multiple cell strings is not specifically limited herein. It should be noted that, in the present embodiment, electrical connection between the cell strings is implemented by additionally providing busbars and other structures.

S206: laminating and encapsulating a front cover plate, the interconnected cell strings, and a backsheet through an outer encapsulation adhesive film to form a laminated assembly

This step is substantially identical to S103 of the above-described embodiment of the disclosure. For detailed content, please refer to the above embodiments, which is not repeated here.

S207: performing edge framing protection and installing a junction box on the laminate assembly to obtain a solar module.

In this step, a frame is provided around the above laminate assembly for edge framing protection, and a junction box is provided, thereby obtain a solar module. The specific content of edge framing protection and installing of a junction box and the specific structures of the devices involved may be set according to actual requirements and are not specifically limited herein.

The embodiment of the present disclosure provides a method for manufacturing a solar cell module. By performing two encapsulation processes respectively, wherein a first encapsulation connects the solder ribbons 2 with the cells 1 through the adhesive film, and a second encapsulation encapsulates the cell strings, a uniform and high-quality encapsulation can be accomplished. By increasing the amount of gap-filling adhesive film between the cells, lamination bubbles arising from local adhesive deficiency of a low-flow adhesive film can be eliminated. The double encapsulations enable high-density encapsulation between the cell strings, thereby improving the efficiency of a photovoltaic module.

The present disclosure further provides a solar cell module, which is a solar cell module manufactured by the method for manufacturing a solar cell module provided in any one of the above embodiments of the present disclosure. The respective components involved therein have been described in detail in the above embodiments of the disclosure, including the inner encapsulation film layer, the outer encapsulation film layer, the cell 1, and the like.

The embodiments of the present disclosure provide a solar cell module, comprising a cell string, an outer encapsulation adhesive film, a front cover plate and a backsheet;
wherein the cell string is obtained by laying a plurality of cells 1 and a solder ribbon 2 on an integral continuous inner encapsulation adhesive film 3, and encapsulating the solder ribbon 2 on a surface of the cell 1 through the inner encapsulation adhesive film 3; wherein the inner encapsulation adhesive film 3 is used to fixedly connect the solder ribbon 2 to the surface of the cell 1;
wherein the plurality of the cell strings are connected to each other, and the outer encapsulation adhesive film connects the front cover plate, the connected cell strings and the backsheet to each other.

Optionally, in an embodiment of the present disclosure, the inner encapsulation adhesive film 3 comprises an integral continuous first inner encapsulation adhesive film 31 and a second inner encapsulation adhesive film 32 corresponding to the cell;
wherein the plurality of cell 1 and the solder ribbon 2 are laid on the first inner encapsulation adhesive film 31 according to a preset structure of the cell strings, a second inner encapsulation adhesive films 32 is laid on a surface of the cell 1 facing away from the first inner encapsulation adhesive film 31, and a gap is present between adjacent second inner encapsulation adhesive films 32.

Optionally, in an embodiment of the present disclosure, the edge of adjacent cell strings are stacked and isolated from each other through an inner encapsulation adhesive film 3 extending beyond the side of the cells so as to overlap the cell strings.

Optionally, in an embodiment of the present disclosure, the edge of adjacent cell strings are stacked and isolated from each other through a first inner encapsulation adhesive film 31 extending beyond the side of the cell string so as to overlap the cell strings.

Optionally, in an embodiment of the present disclosure, the edge of adjacent cells 1 in the cell string are stacked and isolated from each other through a second inner encapsulation adhesive film 32 extending beyond the side of the cells 1 so as to overlap the cells 1.

Optionally, in an embodiment of the present disclosure, the first inner encapsulation adhesive film 31 has a hollow structure 33 in a non-encapsulation region corresponding to outer side the solder ribbon 2.

Optionally, in an embodiment of the present disclosure, the second inner encapsulation adhesive film 32 has a hollow structure 33 in a non-encapsulation region corresponding to outer side the solder ribbon 2.

Optionally, in an embodiment of the present disclosure, the second inner encapsulation adhesive film 32 is a plurality of films covering the solder ribbon 2 located on the surface of the cell 1 facing away from the back plate 4.

Optionally, in an embodiment of the present disclosure, the cell 1 includes a busbar-free cell 1; and the solder ribbon 2 is a low-temperature solder ribbon 2.

Optionally, in an embodiment of the present disclosure, the outer encapsulation adhesive film has a fluidity greater than that of the inner encapsulation adhesive film 3.

Optionally, in an embodiment of the present disclosure, the laminated assembly is a laminated assembly with edge framing protection, and the laminated assembly is provided with a junction box.

Since the solar cell module provided in an embodiment of the present disclosure is manufactured based on the above method for manufacturing a solar cell module, the solar cell module has higher encapsulation quality and higher photovoltaic module efficiency. The specific contents of the respective components thereof have been described in detail in the above embodiments of the disclosure, and will not be repeated herein.

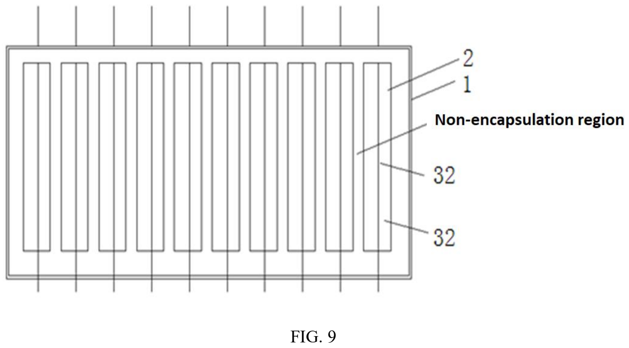

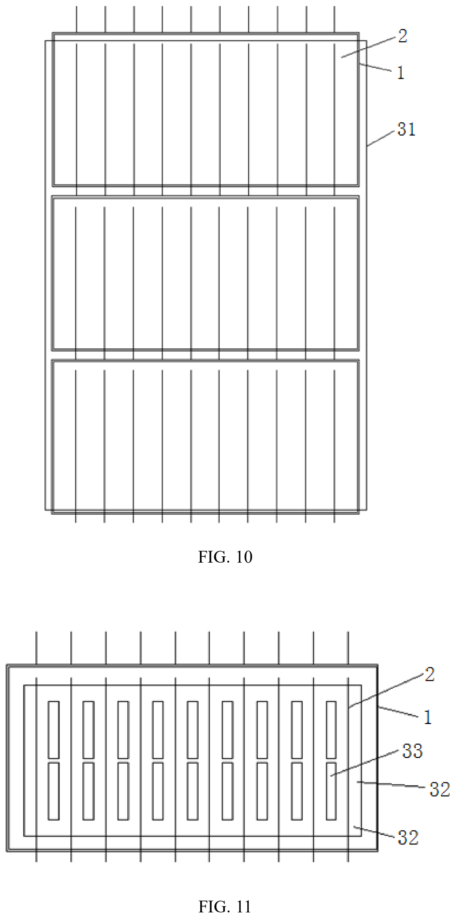

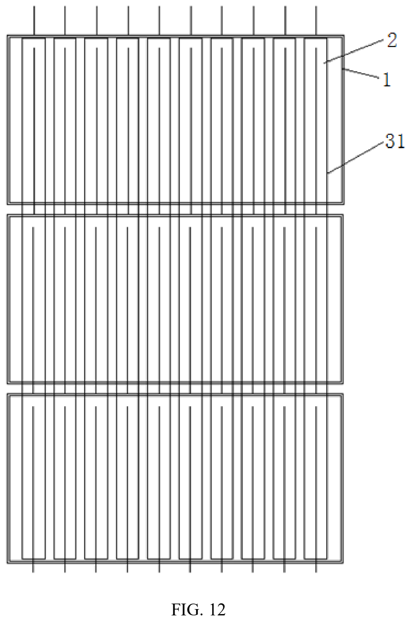

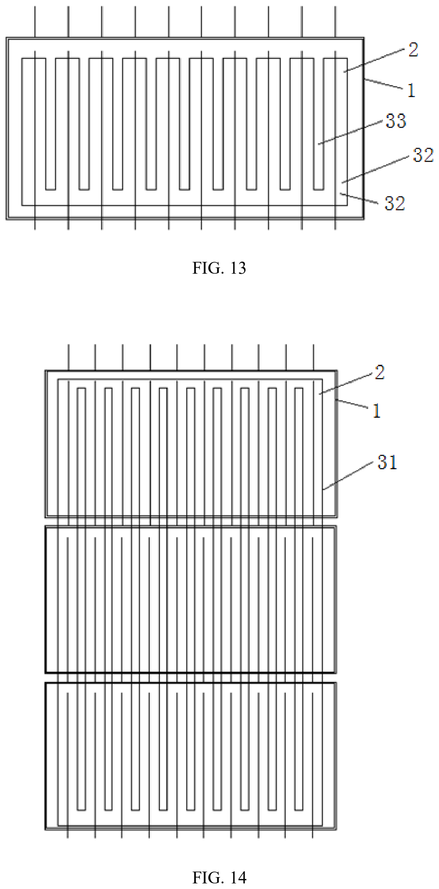

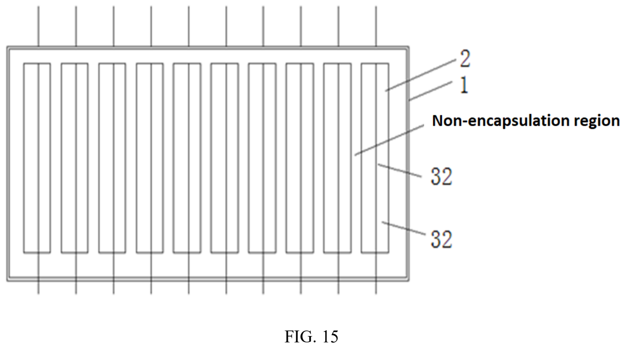

Reference is made to FIG.9 to FIG. 15, FIG. 9 is a schematic top view of the first encapsulation in a first solar cell module manufacture method; FIG. 10 is a schematic bottom view of the first encapsulation in the first solar cell module manufacture method; FIG. 11 is a schematic top view of the first encapsulation in a second solar cell module manufacture method; FIG. 12 is a schematic bottom view of the first encapsulation in the second solar cell module manufacture method; FIG. 13 is a schematic top view of the first encapsulation in a third solar cell module manufacture method; FIG. 14 is a schematic bottom view of the first encapsulation in the third solar cell module manufacture method; FIG. 15 is a schematic top view of the first encapsulation in a fourth solar cell module manufacture method.

The examples of the present disclosure specifically provides four examples, wherein the differences among the following four examples are mainly the difference in structures of the encapsulation adhesive films.

### Example 1

As shown in FIG. 9 and FIG. 10, in the present example, a low-temperature solder ribbon was encapsulated on both sides of a cell 1 by an inner encapsulation adhesive film 3 to form a cell string; subsequently the cell string was encapsulated by an outer encapsulation adhesive film, with only the junction box was led out, while all other regions were not exposed to air. The outer side of the encapsulation adhesive film was front glass and back glass.

The cell 1 was a TOPCon cell. The cell is connected to a busbar pad and fine grid lines of the cell through lamination between the solder ribbon 2. The low-temperature solder ribbon had a surface melting point of 90°C to 137 °C. The inner encapsulation adhesive film 3 serving as a low-flow encapsulation adhesive film had a crosslinking degree in the range of 10% to 75%, and had a thickness of 100 ±10 µm. The outer encapsulation adhesive film was a combination of EVA and POE, for example a POE adhesive film was used on the front side, and an EVA adhesive film was used on the rear side.

During manufacture of the cell string, a continuous first inner encapsulation adhesive film 31 was laid along a preset direction on a back plate 4 with movable adsorption bottom. Then, in sequence, a low-temperature solder ribbon was drawn, the cell 1 was laid, a low-temperature solder ribbon was drawn, a second inner encapsulation adhesive film 32 was laid, a pressing tool 6 was applied, and the platform was moved to a heating source 42 for heating, thereby a weak encapsulation was formed.

The length of the first inner encapsulation adhesive film 31 was slightly shorter than the length of the cell string, and the width exceeded the cell width by 10 mm. The adhesive film was made of EVA. The second inner encapsulation adhesive film 32 had a width of 5 mm to 10 mm, and a length of cell string ±5 mm along the extending direction of solder ribbon 2 and the second inner encapsulation film was a plurality of strip-shaped POE films covering the solder ribbon 2. The back plate 4 was heated to 100 ± 30 °C, and a pressure of 0.1 N/cm ² to 100 N/cm² was applied by pressing tool 6 on the inner encapsulation adhesive film 3.

During secondary encapsulation, the cell strings obtained from the first encapsulation were connected in series/parallel, with the adjacent strings had a spacing of -1 ±1 mm. Then, on the outer side of the cell string array, a front side POE adhesive film, a rear side EVA outer encapsulation adhesive film, a front glass, and a backsheet were sequentially stacked and laminated to form a laminate assembly. And finally, an edge framing protection was applied and a lead-out junction box was installed. As shown in FIG. 7, the edge of adjacent cell strings were stacked and isolated from each other through an inner encapsulation adhesive film 3, typically the first inner encapsulation adhesive film 31, extending beyond the side of the cells. That is, the edge portion of the first inner encapsulation adhesive film 31 was clamped within the overlapping region 7 by the edge portion of the two adjacent cell strings. This design reduced the stress in the overlapping region 7, avoided hidden cracks of the cells 1, eliminated the gap between the adjacent cell strings, and reduced the non-power-generating region of the module. Similarly, within a single cell string, adjacent cells 1 were isolated and stacked by the second inner encapsulation adhesive film 32, which improving the problem of hidden cracks of the cells 1, eliminated the gap between the adjacent cells 1, and reduced the non-power-generating region of the module.

### Example 2

As shown in FIG. 11 and FIG. 12, in the present example, a low-temperature solder ribbon was encapsulated on both sides of the cell 1 by an inner encapsulation adhesive film 3 to form a cell string; subsequently the cell string was encapsulated by an outer encapsulation adhesive film, with only the junction box was led out, while all other regions were not exposed to air. The outer side of the encapsulation adhesive film was front glass and back glass.

The cells had a HJT structure and only comprised of busbar-free cells with fine grid lines. The low-temperature solder ribbon had a surface melting point of 90°C to 137 °C. The inner encapsulation adhesive film 3 serving as a low-flow encapsulation adhesive film had a crosslinking degree in the range of 10% to 75%, and had a thickness of 80 ± 10 µm. The outer encapsulation adhesive film was a combination of EVA and POE, for example a POE adhesive film was used on the front side, and an EVA adhesive film was used on the rear side.

During manufacture of the cell string, a continuous first inner encapsulation adhesive film 31 was laid along a preset direction on a back plate 4 with movable adsorption bottom. Then, in sequence, a low-temperature solder ribbon was drawn, the cell 1 was laid, a low-temperature solder ribbon was drawn, a second inner encapsulation adhesive film 32 was laid, a pressing tool 6 was applied, and the platform was moved to a heating source 42 for heating, thereby a weak encapsulation was formed.

The first inner encapsulation adhesive film 31 was a plurality of strip-shaped adhesive film, which had a length of slightly shorter than the length of the cell string by 5 mm, and the width of 2 mm to 10 mm. The adhesive film was made of POE. The second inner encapsulation adhesive film 32 was an EVA adhesive film having an internal hollow width of 5 mm to 10 mm and, in the length direction along the preset direction, a hole-type array with dimensions of 10 mm to 50 mm. The back plate 4 was heated to 80 ±30 °C, and a pressure of 0.1 N/cm ² to 100 N/cm² was applied by pressing tool 6 on the inner encapsulation adhesive film 3.

During secondary encapsulation, the cell strings obtained from the first encapsulation were connected in series/parallel, with the adjacent strings had a spacing of 1 ±1 mm. Then, on the outer side of the cell string array, a front-side EVA adhesive film, a rear side POE outer encapsulation adhesive film, a front glass, and a backsheet were sequentially stacked and laminated to form a laminate assembly. And finally, an edge framing protection was applied and a lead-out junction box was installed. The adjacent cell strings were stacked and isolated from each other through the first inner encapsulation adhesive film 31 extending beyond the side of the cells.

### Example 3

As shown in FIG. 13 and FIG. 14, in the present example, a low-temperature solder ribbon was encapsulated on both sides of the cell 1 by an inner encapsulation adhesive film 3 to form a cell string; subsequently the cell string was encapsulated by an outer encapsulation adhesive film, with only the junction box was led out, while all other regions were not exposed to air. The outer side of the encapsulation adhesive film was front glass and back glass.

The cell had a PERC structure and only comprised of busbar-free cells with fine grid lines. The low-temperature solder ribbon had a surface melting point of 90°C to 137 °C. The inner encapsulation adhesive film 3 serving as a low-flow encapsulation adhesive film had a crosslinking degree in the range of 10% to 75%, and had a thickness of 80 ± 1 0 µm. The outer encapsulation adhesive film was a PVB adhesive film.

During manufacture of the cell string, a continuous first inner encapsulation adhesive film 31 was laid along a preset direction on a back plate 4 with a movable adsorption bottom. Then, in sequence, a low-temperature solder ribbon was drawn, the cell 1 was laid, a low-temperature solder ribbon was drawn, a second inner encapsulation adhesive film 32 was laid, a pressing tool 6 was applied, and the platform was moved to a heating source 42 for heating, thereby a weak encapsulation was formed.

The first inner encapsulation adhesive film 31 was a mesh-type adhesive film which had a length of slightly shorter than the length of the cell string by 5 mm, and contained multiple hollow regions arranged in parallel with a width of 2 mm to 10 mm. The adhesive film was made of PVB. The above second inner encapsulation adhesive film 32 was a serrated PVB adhesive film having a hollow region on one side with a width of 5 mm to 10 mm. The back plate 4 was heated to 170 ±30 °C, and a pressure of 0.1 N/cm ² to 100 N/cm² was applied by pressing tool 6 on the inner encapsulation adhesive film 3.

During secondary encapsulation, the cell strings obtained from the first encapsulation were connected in series/parallel, with the adjacent strings had a spacing of 1 ±1 mm. Then, on the outer side of the cell string array, a front-side PVB film, a rear side PVB outer encapsulation adhesive film, a front glass, and a backsheet were sequentially stacked and laminated to form a laminate assembly. And finally, an edge framing protection was applied and a lead-out junction box was installed. The adjacent cell strings are stacked and isolated from each other through the first inner encapsulation adhesive film 31 extending beyond the side of the cells.

### Example 4

As shown in FIG. 15, in the present example, a low-temperature solder ribbon was encapsulated on both sides of the cell 1 by an inner encapsulation adhesive film 3 to form a cell string; subsequently the cell string was encapsulated by an outer encapsulation adhesive film, with only the junction box was led out, while all other regions were not exposed to air. The outer side of the encapsulation adhesive film was front glass and back glass.

The cell had a back-contact structure and included, but was not limited to, a busbar-free cell. The low-temperature solder ribbon had a surface melting point of 90°C to 137 °C. The inner encapsulation adhesive film 3 serving as a low-flow encapsulation adhesive film had a crosslinking degree in the range of 10% to 75%, and had a thickness of 80 ± 10 µm. The outer encapsulation adhesive film was an EVA adhesive film.

During manufacture of the cell string, a continuous first inner encapsulation adhesive film 31 was laid along a preset direction on a back plate 4 with a movable adsorption bottom. Then, in sequence, a low-temperature solder ribbon was drawn, the cell 1 was laid, a low-temperature solder ribbon was drawn, a second inner encapsulation adhesive film 32 was laid, a pressing tool 6 was applied, and the platform was moved to a heating source 42 for heating, thereby a weak encapsulation was formed.

The second inner encapsulation adhesive film 32 was an EVA adhesive film which contained multiple hollow regions arranged in parallel with a width of 5 mm to 10 mm. The back plate 4 was heated to 70 ± 30 °C, and a pressure of 0.1 N/cm ² to 100 N/cm² was applied by pressing tool 6 on the inner encapsulation adhesive film 3.

During secondary encapsulation, the cell strings obtained from the first encapsulation were connected in series/parallel, with the adjacent strings had a spacing of 0.5 ±1 mm. Then, on the outer side of the cell string array, a front-side EVA film, a rear side POE outer encapsulation adhesive film, a front glass, and a backsheet were sequentially stacked and laminated to form a laminate assembly. And finally, an edge framing protection was applied and a lead-out junction box was installed. The adjacent cell strings are stacked and isolated from each other through the first inner encapsulation adhesive film 31 extending beyond the side of the cells.

In the present specification, the respective embodiments are described in a progressive manner, and each embodiment is mainly illustrated in terms of its differences from the other embodiments, while identical or similar parts among the embodiments are simply referred to each other. For the apparatus disclosed in the embodiments, since it corresponds to the method disclosed in the embodiments, the description is simplified, and relevant parts are referred to the method section.

A skilled person can further recognize that the units and algorithm steps of the various examples described in the embodiments disclosed herein can be implemented by electronic hardware, computer software, or a combination of both. To clearly illustrate the interchangeability between hardware and software, the components and steps of the examples are generally described functionally in the above description. Whether these functions are implemented by hardware or software depends on the specific application and design constraints of the technical solution. A skilled person can use different methods for each specific application to implement the described functions; however, such implementations are not considered to fall outside the scope of the present disclosure.

The steps of the methods or algorithms described in the embodiments disclosed herein can be implemented directly by hardware, by software modules implemented by a processor, or by a combination of both. The software modules may be stored in a random access memory (RAM), a memory, a read-only memory (ROM), an electrically programmable ROM, an electrically erasable programmable ROM, a register, a hard disk, a removable disk, a CD-ROM, or any other form of storage medium known in the art.

Finally, it should further noted that relational terms such as "first" and "second" in this document are only used to distinguish one entity or operation from another entity or operation, and do not necessarily require or imply any actual relationship or sequence between them. Moreover, the terms "comprise," "include," or any other variations thereof are intended to cover a non-exclusive inclusion, such that a process, method, article, or apparatus that comprises a series of elements not only comprises those elements, but also comprises other elements not explicitly listed, or comprises elements inherent to such process, method, article, or apparatus. Without further limitations, an element defined by the phrase "comprise a ..." does not exclude the presence of additional identical elements in the process, method, article, or apparatus comprising the element.

A method for manufacturing a solar cell module and a solar cell module provided by the present disclosure are described in detail above. Specific embodiments are used herein to illustrate the principles and implementations of the present disclosure. The descriptions of the above embodiments are intended only to assist in understanding the method and core concept of the present disclosure. It should be noted that, for an ordinary person skilled in the art, various modifications and alterations can be made without departing from the principles of the present disclosure, and such modifications and alterations also fall within the protection scope of the claims of the present disclosure.

## Claims

1. A method for manufacturing a solar cell module, comprising steps of:
laying a plurality of cells and a solder ribbon on an integral continuous inner encapsulation adhesive film, and encapsulating the solder ribbon on a surface of the cells through the inner encapsulation adhesive film to form a cell string; wherein the inner encapsulation adhesive film is used to fixedly connect the solder ribbon to the surface of the cells;
connecting the cell strings to each other;
laminating and encapsulating a front cover plate, the interconnected cell strings, and a backsheet through an outer encapsulation adhesive film to form a laminated assembly; wherein the outer encapsulation adhesive film is located between the cell strings and the front cover plate, and between the cell strings and the backsheet; and
fabricating the solar cell module based on the laminated assembly.

2. The method according to claim 1, wherein the step of laying a plurality of cells and a solder ribbon on an integral continuous inner encapsulation adhesive film and encapsulating the solder ribbon on a surface of the cells through the inner encapsulation adhesive film to form a cell string comprises steps of:
laying an integral continuous first inner encapsulation adhesive film on a surface of a back plate;
laying the solder ribbon and a plurality of cells on a surface of the first inner encapsulation adhesive film according to a preset structure of the cell strings;
laying a second inner encapsulation adhesive film corresponding to each of the cells on a surface of the cells facing away from the back plate; wherein the first inner encapsulation adhesive film and the second inner encapsulation adhesive films are used to fixedly connect the solder ribbon to the surface of the cells; wherein a gap is present between adjacent second inner encapsulation adhesive films; and
placing a pressing tool on a surface of the second inner encapsulation adhesive film and performing heating to encapsulate the solder ribbon on a surface of the cells to form the cell string.

3. The method according to claim 2, wherein the back plate has an adsorption structure to adsorb the first inner encapsulation adhesive film.

4. The method according to claim 3, wherein the first inner encapsulation adhesive film has a hollow structure in a non-encapsulation region corresponding to outer side of the solder ribbon, to allow the adsorption structure to adsorb the cells through the hollow structure.

5. The method according to claim 4, wherein the second inner encapsulation adhesive film has a hollow structure in a non-encapsulation region corresponding to outer side of the solder ribbon.

6. The method according to claim 4, wherein the second inner encapsulation adhesive film is a plurality of adhesive films covering the solder ribbon located on a surface of the cells facing away from the back plate.

7. The method according to claim 1, wherein the cell includes a busbar-free cell, and the solder ribbon is a low-temperature solder ribbon.

8. The method according to claim 1, wherein the outer encapsulation adhesive film has a fluidity greater than that of the inner encapsulation adhesive film.

9. The method according to claim 1, wherein the step of fabricating the solar cell module based on the laminated assembly comprises steps of:
performing edge framing protection and junction box installation on the laminated assembly to obtain the solar cell module.

10. The method according to claim 2, wherein the step of connecting the cell strings to each other comprises:
stacking and isolating the edge of adjacent cell strings through inner encapsulation adhesive film extending beyond the side of the cells, so as to overlap the cell strings.

11. The method according to claim 10, wherein the step of stacking and isolating the edge of adjacent cell strings through inner encapsulation adhesive film extending beyond the side of the cells so as to overlap the cell strings comprises:
stacking and isolating the edge of adjacent cell strings through the first inner encapsulation adhesive film extending beyond the side of the cell strings, so as to overlap the cell strings.

12. The method according to claim 11, wherein the step of laying the second inner encapsulation adhesive film corresponding to each of the cells on the surface of the cells facing away from the back plate comprises:
stacking and isolating the edge of adjacent cells through the second inner encapsulation adhesive film extending beyond the side of the cell, so as to overlap the cells.

13. A solar cell module, comprising a cell string, an outer encapsulation adhesive film, a front cover plate and a back plate;
wherein the cell string is obtained by laying a plurality of cells and a solder ribbon on an integral continuous inner encapsulation adhesive film and encapsulating the solder ribbon on a surface of the cells through the inner encapsulation adhesive film; and the inner encapsulation adhesive film is used to fixedly connect the solder ribbon to a surface of the cells;
wherein a plurality of the cell strings is connected to each other, and the outer encapsulation adhesive film connects the front cover plate, the connected cell strings and the backsheet to each other.

14. The solar cell module according to claim 13, wherein the inner encapsulation adhesive film comprises an integral continuous first inner encapsulation adhesive film and a second inner encapsulation adhesive film corresponding to the cells;
wherein the plurality of cells in the cell string and the solder ribbon are laid on a surface of the first inner encapsulation adhesive film according to a preset structure of the cell strings, the second inner encapsulation adhesive films is laid on a surface of the cells facing away from the first inner encapsulation adhesive film, and a gap is present between adjacent second inner encapsulation adhesive films.

15. The solar cell module according to claim 14, wherein the edge of adjacent cell strings are stacked and isolated from each other through an inner encapsulation adhesive film extending beyond the side of the cells so as to overlap the cell strings.

16. The solar cell module according to claim 15, wherein the edge of adjacent cell strings are stacked and isolated from each other through a first inner encapsulation adhesive film extending beyond the side of the cell strings so as to overlap the cell strings.

17. The solar cell module according to claim 15, wherein the edge of adjacent cells in the cell strings are stacked and isolated from each other through a second inner encapsulation adhesive film extending beyond the side of the cells so as to overlap the cells.

18. The solar cell module according to claim 14, comprising a plurality of the second inner encapsulation adhesive films, wherein a plurality of solder ribbons are provided on a side surface of the cells; the second inner encapsulation adhesive films correspond one-to-one to the solder ribbons on a side of the cells and encapsulate the corresponding solder ribbons on a surface of the cells.
